Europäisches Patentamt

European Patent Office

Office européen des brevets

(19)

(11) Numéro de publication : **0 284 474 B1**

(12) **FASCICULE DE BREVET EUROPEEN**

(45) Date de publication du fascicule du brevet :
29.04.92 Bulletin 92/18

(51) Int. Cl.⁵ : **H03H 9/08**

(21) Numéro de dépôt : **88400515.8**

(22) Date de dépôt : **04.03.88**

(54) **Ressorts de suspension d'une lame vibrante piézoélectrique.**

(30) Priorité : **06.03.87 FR 8703074**

(43) Date de publication de la demande :
**28.09.88 Bulletin 88/39**

(45) Mention de la délivrance du brevet :
**29.04.92 Bulletin 92/18**

(84) Etats contractants désignés :
**AT BE CH DE ES FR GB IT LI LU NL SE**

(56) Documents cités :
**US-A- 2 814 741**
**US-A- 3 909 639**
**US-A- 4 292 562**
**US-A- 4 410 827**

(73) Titulaire : **COMPAGNIE D'ELECTRONIQUE ET DE PIEZO-ELECTRICITE - C.E.P.E.**
**44, rue de la Glacière**
**F-95100 Argenteuil (FR)**
Titulaire : **Office National d'Etudes et de Recherches Aérospatiales (O.N.E.R.A.)**
**29 Avenue de la Division Leclerc**
**F-92320 Châtillon-sous-Bagneux (FR)**

(72) Inventeur : **Aubry, Jean-Pierre**
**THOMSON-CSF SCPI 19, avenue de Messine**
**F-75008 Paris (FR)**
Inventeur : **Fragneau, Marc**
**THOMSON-CSF SCPI 19, avenue de Messine**
**F-75008 Paris (FR)**
Inventeur : **Craveur, Jean-Charles**
**THOMSON-CSF SCPI 19, avenue de Messine**
**F-75008 Paris (FR)**
Inventeur : **Janiaud, Denis**
**THOMSON-CSF SCPI 19, avenue de Messine**
**F-75008 Paris (FR)**
Inventeur : **Muller, Serge**
**THOMSON-CSF SCPI 19, avenue de Messine**
**F-75008 Paris (FR)**

(74) Mandataire : **Guérin, Michel et al**
**THOMSON-CSF SCPI**
**F-92045 PARIS LA DEFENSE CEDEX 67 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

EP 0 284 474 B1

## Description

La présente invention concerne des ressorts de suspension de lames vibrantes piézoélectriques et permettant la fabrication de résonateurs à faible sensibilité accélérométrique.

Les lames piézoélectriques destinées à la fabrication de résonateurs sont généralement fixées sur une embase au moyen de ressorts métalliques souvent constitués d'une bande de nickel formée. Ces ressorts servent de filtres mécaniques et sont par conséquent indispensables.

Sous l'effet d'une accélération, ces ressorts se déforment ce qui provoque une déformation de la lame piézoélectrique qu'ils maintiennent. Cette déformation de la lame vibrante entraîne une variation de la fréquence de résonance du résonateur qui est suffisamment importante pour dépasser les tolérances admissibles dans certains dispositifs. Un moyen connu de remédier à cet inconvénient consiste à prévoir cette variation de fréquence. La lame piézoélectrique est alors conçue pour résonner, en l'absence d'accélération, à une fréquence proche mais différente de la fréquence désirée et pour résonner à la fréquence désirée pour une accélération déterminée. Outre la difficulté que représente cette approche en fréquence, ce remède n'est valable que pour une valeur d'accélération particulière et la fréquence de résonance sera rapidement hors tolérance pour des valeurs d'accélération qui s'écartent trop de cette valeur particulière.

On connaît par les brevets US-A-4 410 827 et US-A-3 909 639 des ressorts de suspension de lame vibrante piézoélectrique comportant au moins deux parties : une partie principale fixée d'un côté sur une embase et reliée de l'autre à une languette supportant la lame vibrante. Mais ces ressorts n'ont pas de dimensions appropriées pour minimiser la déformation de la lame vibrante soumise à une accélération.

Afin de pallier ces inconvénients, l'invention propose des ressorts de suspension de conception originale, comprenant au moins deux parties : une partie destinée à être fixée sur l'embase du résonateur et une partie destinée à supporter la lame vibrante. La géométrie de ces parties, leur dimensions ainsi que leur arrangement particulier font que les ressorts selon l'invention se déforment sous l'effet d'une accélération mais n'entraînent qu'une faible déformation de la lame vibrante et par conséquent une faible variation de sa fréquence de résonance, ce qui permet le respect des tolérances imposées.

L'invention a pour objet un ressort de suspension d'une lame vibrante piézoélectrique comprenant une partie principale de hauteur H, de largeur 1, d'épaisseur e. Cette partie principale est fixée d'un côté sur une embase et, de l'autre est reliée sur une première extrémité d'une languette de hauteur h, de largeur 1', d'épaisseur e'. L'autre extrémité de la languette supporte la lame vibrante. La lame vibrante et l'embase sont situées d'un même côté par rapport à la liaison entre la partie principale et la languette. Lorsque l'épaisseur e' est sensiblement égale à e, les hauteurs H et h sont telles que :

$(l/l') \times (h/H)^2 + 2 \times (h/H) - 1$ soit sensiblement égal à zéro

et lorsque e' est supérieur ou égal à deux fois e,

$h = H/2$.

L'invention sera mieux comprise et d'autres avantages apparaîtront à la lecture de la description qui va suivre, donnée à titre non limitatif, et grâce aux dessins annexés parmi lesquels :
  – la figure 1 représente une lame vibrante maintenue par des ressorts selon l'art connu,
  – la figure 2 représente le dispositif de la figure 1 soumis à une accélération,
  – la figure 3 représente une lame vibrante maintenue par des ressorts selon l'invention,
  – la figure 4 représente le dispositif de la figure 3 soumis à une accélération,
  – les figures 5 à 10 représentent des ressorts selon l'invention,
  – les figures 11 et 12 illustrent la réalisation d'un ressort selon l'invention.

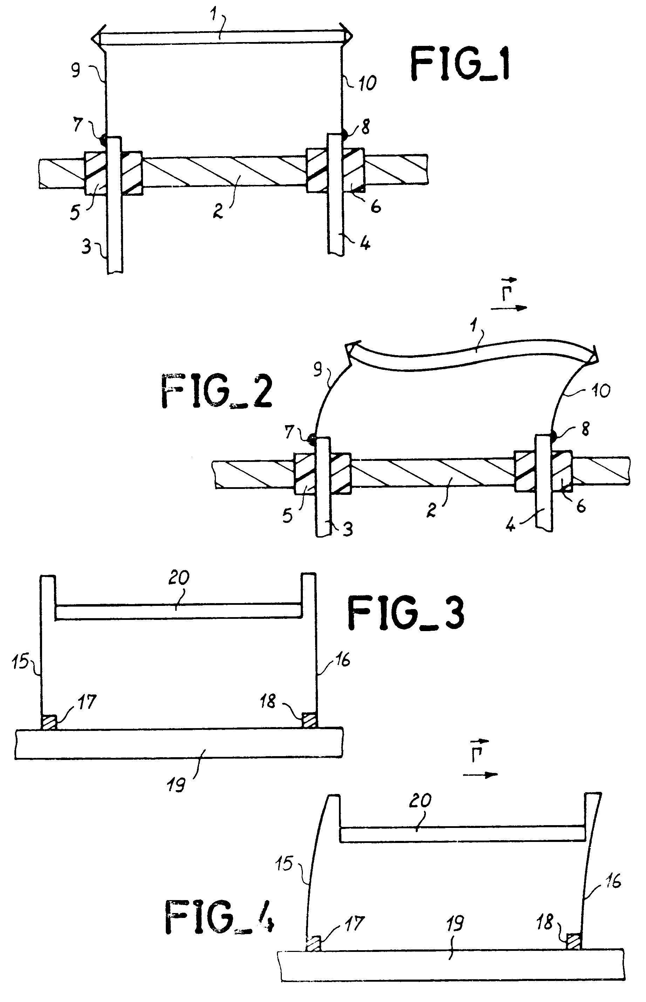

La figure 1 illustre, selon l'état de l'art, la manière de maintenir une lame piézoélectrique 1 au-dessus d'une embase 2 traversée par les poteaux conducteurs 3 et 4 servant de bornes de sortie au résonateur. Des perles de verre 5 et 6 permettent d'isoler les poteaux de l'embase. Sur ces poteaux sont fixés, par des points de soudure 7 et 8, des ressorts conducteurs 9 et 10. Les ressorts sont formés pour que leurs extrémités opposées aux poteaux aient des formes en V en regard l'une de l'autre pour pouvoir maintenir la lame vibrante 1. Chaque face de la lame 1 est munie d'une électrode qui peut être reliée électriquement à l'un des ressorts par un point de colle conductive non représenté. Une continuité électrique est ainsi assurée entre les poteaux et les électrodes de la lame vibrante. Un boîtier de protection sera ensuite posé et fixé sur l'embase. En l'absence d'accélération, le résonateur ainsi constitué possède une fréquence de résonance $f_o$.

Si le résonateur décrit ci-dessus est soumis à une accélération $\vec{\Gamma}$ parallèle au plan de la lame et dans le plan de déplacement des ressorts, la lame vibrante va se déformer de la manière illustrée de façon exagérée à la figure 2. Cette déformation, en forme de S, est due à la déformation des ressorts de suspension 9 et 10. Dans ces conditions la fréquence de résonance du résonateur sera différente de $f_o$ et si l'accélération est suffisamment élevée, cette fréquence sera située en dehors de la gamme de variation tolérée.

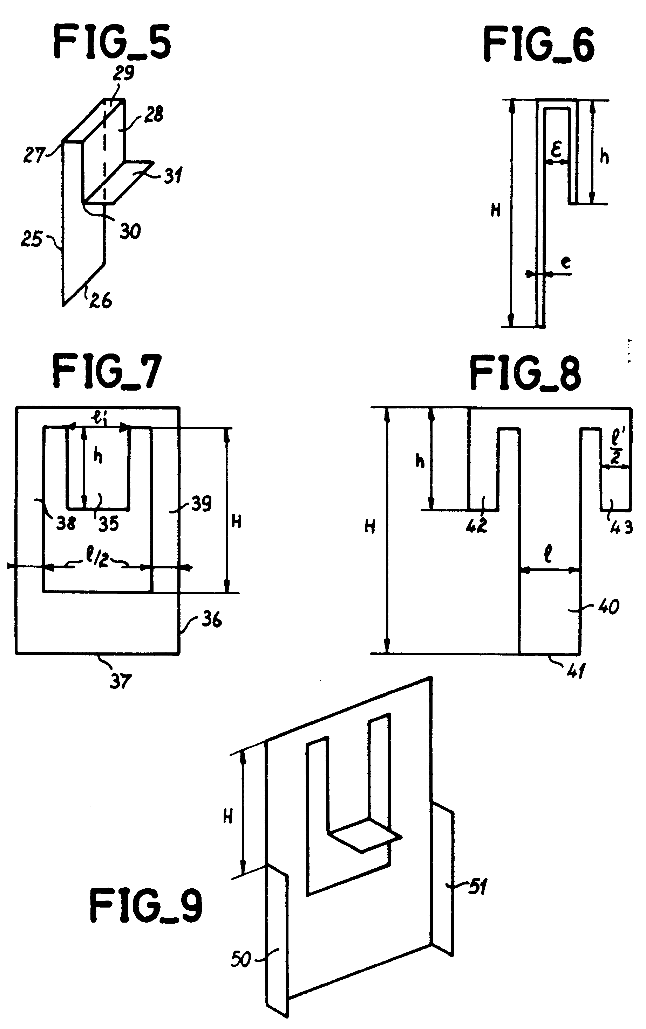

Les ressorts selon l'invention se déforment lorsqu'ils sont soumis à une accélération, mais cette déformation entraîne une déformation de la lame vibrante nettement inférieure à la déformation du dispositif selon l'art connu. C'est ce que montrent les figures 3 et 4. Les ressorts 15 et 16 fixés, par exemple par des points de soudure 17 et 18, sur l'embase 19 supportent la lame vibrante 20. La lame 20 peut être fixée aux ressorts par des points de colle conductrice. La figure 3 représente le résonateur en l'absence d'accélération. La figure 4 représente le même résonateur soumis à l'accélération $\overrightarrow{\Gamma}$. Dans ce cas ce sont les ressorts qui subissent toute l'accélération tandis que la lame vibrante n'est pas sensiblement déformée.

Le ressort selon l'invention comprend au moins deux parties solidaires entre elles ou éventuellement reliées par une troisième partie. La première partie est celle qui sera fixée sur l'embase, directement ou par l'intermédiaire d'un poteau traversant cette embase. La seconde partie est une languette dont une extrémité est destinée à supporter la lame vibrante. Cette extrémité porteuse est l'extrémité de la languette qui se trouve la plus proche du point de fixation de la première partie sur l'embase.

La figure 5 représente un ressort de suspension selon l'invention. Il est constitué d'une bande repliée plusieurs fois. Il comprend une première partie 25 dont une extrémité 26 est destinée à être fixée sur l'embase du résonateur et dont l'extrémité opposée 27 est solidaire de la languette 28 grâce à une partie intermédiaire 29. La languette 28 est située dans un plan parallèle au plan de la partie 25. L'extrémité 30 de la languette est destinée à supporter la lame vibrante. Elle est bien l'extrémité de la languette la plus proche du point de fixation du ressort sur l'embase du résonateur. Elle peut avantageusement être prolongée d'une partie 31 qui permet la réception aisée, entre deux ressorts de même type, d'une lame vibrante. Une fois la lame vibrante posée sur ces parties réceptrices 31, il suffit de déposer des points de colle pour fixer la lame aux ressorts, la colle adhérant aux partie 30 et/ou 31.

Pour obtenir le meilleur rendement des ressorts selon l'invention, il est souhaitable de respecter certaines conditions géométriques. La figure 6 reprend la forme retenue précédemment. On suppose que le ressort a été fabriqué à partir d'une bande métallique d'épaisseur constante e, que cette bande a été pliée pour obtenir des parties de longueurs h et H écartées d'une distance ε comme l'indique la figure 6. La distance H est mesurée à partir du point de fixation du ressort sur le poteau correspondant ou sur l'embase. Les meilleurs résultats sont ceux pour lesquels : $\varepsilon \leqq 3$ e et $\dfrac{h}{H} \simeq 0,5$.

On peut concevoir, pour les ressorts selon l'invention, d'autres formes que celle représentée à la figure 5 en particulier des formes où la distance ε est nulle.

La figure 7 représente un ressort de ce type réalisé à partir d'une pièce rectangulaire. La languette 35 est située dans le même plan que la partie 36 qui sera fixée à son extrémité inférieure 37 sur l'embase du résonateur. Comme pour la figure 5, la languette 35 peut être avantageusement prolongée d'une partie réceptrice de la lame vibrante. La languette 35 possède une largeur l' pour une hauteur h. La dimension H dans ce cas est celle correspondant à la hauteur de la lumière en forme de U pratiquée symétriquement dans la pièce. La zone située sous la lumière est considérée comme ayant une rigidité infinie du fait de la fixation sur l'embase. On considère que l'effet ressort est obtenu grâce à la languette 35 et aux deux branches latérales 38 et 39 de largeur $\dfrac{l}{2}$. Si $l = l'$ et pour une pièce d'épaisseur constante, les meilleurs résultats seront obtenus pour $\dfrac{h}{H} = \sqrt{2} - 1$ soit environ 0,5. Si l est différent de l' et pour une pièce d'épaisseur constante, les meilleurs résultats seront obtenus lorsque le rapport $\dfrac{h}{H}$ sera la solution de l'équation suivante :

$$\frac{l}{l'} \times \left(\frac{h}{H}\right)^2 + 2 \left(\frac{h}{H}\right) - 1 = 0$$

La figure 8 représente une autre variante du ressort selon l'invention. Il a une forme en T et est constitué d'une première partie 40 qui sera fixée sur l'embase du résonateur par son extrémité 41, et d'une seconde partie formée de deux demi-languettes 42 et 43 situées de part et d'autre de la première partie. Chaque ressort fournit donc deux points d'appui pour la lame vibrante. Comme précédemment, les demi-languettes peuvent être prolongées d'une partie réceptrice de la lame vibrante. Les dimensions l, l', h et H sont mentionnées sur la figure. Pour une pièce d'épaisseur constante, les meilleurs résultats seront obtenus pour les mêmes conditions que pour le ressort de la figure 7.

La figure 9 est une autre variante de ressort selon l'invention. Elle reprend le type représenté à la figure 7 avec en plus des flancs latéraux 50 et 51 pliés à 90°. Dans ce cas la dimension H sera celle indiquée sur la figure, les flancs latéraux ayant pour effet de supprimer l'effet ressort des zones qui leur sont limitrophes. Ces flancs latéraux peuvent aussi être formés sur les autres ressorts avec les mêmes conséquences.

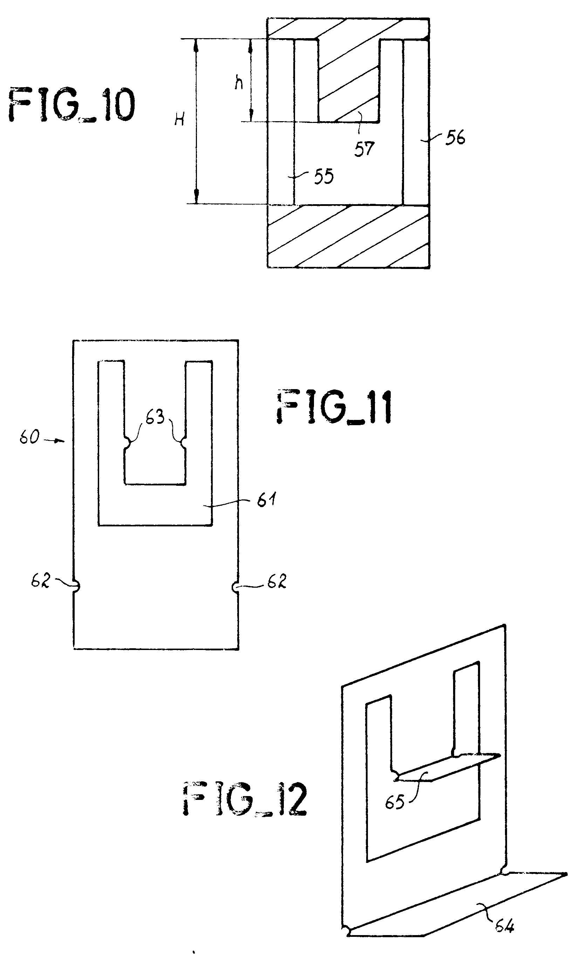

La figure 10 représente une autre réalisation de l'invention. Ce ressort ressemble à celui représenté à la figure 7. Son originalité consiste dans les différences d'épaisseur entre les branches latérales 55 et 56 d'une part et le reste du ressort d'autre part. Les régions hachurées ont une épaisseur e' supérieure à l'épaisseur e des branches latérales 55 et 56. Si e' est suffisamment grand par rapport à e (en fait pour e' $\cong$ 2e), les régions hachurées peuvent être considérées comme rigides vis-à-vis des régions non hachurées. La condition géométrique à respecter pour obtenir les meilleurs résultats devient alors très simple : il faut h = $\frac{H}{2}$. Cette relation est indépentante de la largeur de la languette 57 et de celle des branches latérales. L'avantage de cette solution est que le collage de la lame peut être effectué avec moins de soin puisqu'il est réalisé sur une partie considérée comme rigide. Avec les structures précédentes, on doit éviter les points de colle trop important pour garder une bonne souplesse à la languette, ce qui est une opération délicate à cause de la petite taille des ressorts.

Différentes méthodes peuvent être utilisées pour obtenir des régions d'épaisseurs différentes. On peut partir d'une feuille mince et faire des dépôts locaux par électrodéposition. On peut aussi partir d'une feuille épaisse qui sera usinée par exemple par électro-érosion ou par les techniques d'usinage chimique.

A titre d'exemple, les dimensions du ressort représenté à la figure 10 peuvent être les suivantes :
– dimensions de la pièce de départ : 2,2 mm x 4 mm,
– languette : h =1,32 mm, largeur 0,8 mm,
– H = 2,1 mm,
– largeur des branches latérales 0,4 mm,
– épaisseurs : e' = 0,16 mm, e = 0,08 mm.

Les ressorts selon l'invention peuvent être soudés directement ou non sur les embases. Pour faciliter la mise en place verticale des ressorts on peut leur prévoir une partie repliée servant de base. La figure 11 représente, avant pliage, une pièce métallique 60 destinée à former un ressort selon l'invention. Cette pièce a été obtenue, par exemple, par une opération d'électro-érosion qui a également permis la formation d'une lumière 61 et d'encoches 62 et 63. Comme le montre la figure 12, ces encoches facilitent la pliure de la base 64 du ressort qui sera soudée et la pliure de la partie 65 qui supportera la lame vibrante.

Les ressorts selon l'invention, comme ceux de l'art connu, peuvent être utilisés pour servir de conducteurs électriques jusqu'aux électrodes de la lame vibrante. Le matériau utilisé peut être du nickel de qualité S.

La variation relative de fréquence en fonction de l'accélération est donnée par la relation :

$$\frac{\Delta f}{f} = \vec{K} \cdot \vec{\Gamma}$$

$\vec{K}$ étantle vecteur sensibilité accélérométrique durésonateur. Une mesure de la variation de fréquence en réponse à une accélération donnée permet donc de déterminer la valeur de $\vec{K}$. Des mesures ont été effectuées pour comparer les ressorts selon l'invention à ceux de l'art connu. La lame vibrante utilisée possède les caractéristiques suivantes : fréquence de résonance 10 MHz, coupe SC, fonctionnement en partiel 3, quartz auto-suspendu. Avec les ressorts de l'art connu tels que représentés à la figure 1, K vaut environ $7.10^{-10}$/g. Avec des ressorts tels que celui représenté à la figure 10, K vaut environ $2.10^{-10}$/g. La diminution de ce paramètre a pour conséquence directe une diminution proportionnelle de la dérive en fréquence.

**Revendications**

1. Ressort de suspension d'une lame vibrante piézoélectrique, comprenant une partie principale (36) de hauteur H, de largeur l, d'épaisseur e, cette partie principale (36) devant être fixée d'un côté sur une embase et, de l'autre, étant reliée sur une première extrémité d'une languette (35) de hauteur h, de largeur l', d'épaisseur e', l'autre extrémité de la languette (35) supportant la lame vibrante, la lame vibrante et l'embase étant situées d'un même côté par rapport à la liaison entre la partle principale (36) et la languette (35), caractérisé en ce que, les dimensions H et h sont telles que :
(l/l') x (h/H)² + 2 x (h/H) - 1 est sensiblement égal à zéro lorsque e' est sensiblement égal à e et h = H/2 lorsque e' est supérieur ou égal à deux fois e.

2. Ressort selon la revendication 1, caractérisé en ce qu'il est formé d'une bande repliée plusieurs fois, la partie principale (25) et la languette (28) étant reliées par une partie intermédiaire (29) et étant dans des plans sensiblement parallèles.

EP 0 284 474 B1

3. Ressort selon la revendication 2, caractérisé en ce que, l'épaisseur de la bande étant à peu près constante, la distance séparant la partie principale de la languette représente environ trois fois l'épaisseur de la bande.

4. Ressort selon l'une des revendications 2 ou 3, caractérisé en ce que la largeur de la bande est sensiblement constante, la hauteur h de la languette étant d'environ la moitié de la hauteur H de la partie principale.

5. Ressort selon la revendication 1, caractérisé en ce que le ressort résulte d'une lumière en forme de U pratiquée symétriquement dans une plaque rectangulaire, la lumière définissant la languette (35), la partie principale (36) étant formée de deux branches (38,39) latérales situées de chaque côté de la languette (35), la hauteur H de la partie principale (36) étant la hauteur de la lumière, la largeur l de la partie principale (36) étant le double de la largeur des branches latérales (38,39), l'épaisseur e de la partie principale (36) étant l'épaisseur des deux branches latérales (38,39).

6. Ressort selon la revendication 5, caractérisé en ce que l'épaisseur e des deux branches latérales (38,39) est d'environ la moitié de l'épaisseur du reste de la plaque.

7. Ressort selon la revendication 1, caractérisé en ce qu'il a la forme d'un T avec une barre centrale (40), la languette (42, 43) étant dédoublée en deux demi-languettes situées de chaque côté de la barre centrale, la largeur l de la partie principale étant la largeur de la barre centrale, la hauteur H de la partie principale étant la hauteur du T, la largeur l' de la languette étant le double de la largeur des demi-languettes, la hauteur h de la languette étant la hauteur des demi-languettes.

8. Ressorts selon l'une des revendications 1 à 7, caractérisé en ce que des flancs latéraux (50,51) sont prévus sur la partie principale, du côté de l'extrémité destinée à être fixée sur l'embase.

9. Ressort selon l'une des revendications 1 à 8, caractérisé en ce que la languette est prolongée d'une partie repliée (65) permettant la pose de la lame vibrante.

10. Ressort selon l'une quelconque des revendications 1 à 9, caractérisé en ce que la partie principale est prolongé d'une base (64) repliée permettant la fixation du ressort sur l'embase.

11. Ressort selon l'une des revendications 9 à 10, caractérisé en ce que des encoches (62,63) sont prévues pour faciliter le pliage de la partie repliée (65) et/ou de la base (64).


**Patentansprüche**

1. Tragfeder für ein piezoelektrisches, schwingendes Plättchen, mit einem Hauptteil (36) der Höhe H, der Breite l und der Dicke e, wobei dieser Hauptteil (36) einerseits an einer Befestigungsfläche und andererseits an einem ersten Ende einer Lasche (35) mit der Höhe h, der Breite l' und der Dicke e' befestigt ist, wobei das andere Ende der Lasche (35) das schwingende Plättchen trägt, wobei das schwingende Plättchen und die Befestigungsfläche auf derselben Seite in bezug auf die Verbindung zwischen dem Hauptteil (36) und der Lasche (35) angeordnet sind, dadurch gekennzeichnet, daß die Abmessungen H und h derart sind, daß $(l/l') \cdot (h/H)2 + 2 \cdot (h/H) - 1$ im wesentlichen gleich Null ist, wenn e' im wesentlichen gleich e ist, und daß h = H/2 ist, wenn e' größer oder gleich dem Zweifachen von e ist.

2. Feder gemäß Anspruch 1, dadurch gekennzeichnet, daß sie aus einem mehrmals geknickten Streifen gebildet ist, wobei der Hauptteil (25) und die Lasche (28) über einen Zwischenbereich (29) verbunden sind und in im wesentlichen parallelen Ebenen liegen.

3. Feder gemäß Anspruch 2, dadurch gekennzeichnet, daß die Dicke des Streifens ungefähr konstant ist, wobei der Abstand, der den Hauptteil von der Lasche trennt, im wesentlichen die dreifache Dicke des Streifens besitzt.

4. Feder gemäß einem der Ansprüche 2 oder 3, dadurch gekennzeichnet, daß die Breite des Streifens im wesentlichen konstant ist, wobei die Höhe h der Lasche im wesentlichen gleich der Hälfte der Höhe H des Hauptteils ist.

5. Feder gemäß Anspruch 1, dadurch gekennzeichnet, daß die Feder ein Schlitzloch in Form eines U, das in einer rechtwinkligen Platte symmetrisch ausgebildet ist, ergibt, wobei das Schlitzloch die Lasche (35) definiert, wobei der Hauptteil (36) aus zwei auf jeder Seite der Lasche (35) befindlichen Seitenarmen (38, 39) gebildet ist, wobei die Höhe H des Hauptteils (36) die Höhe des Schlitzlochs ist, wobei die Breite l des Hauptteils (36) die doppelte Breite der Seitenarme (38, 39) besitzt und wobei die Dicke e des Hauptteils (36) gleich der Dicke der zwei Seitenarme (38, 39) ist.

6. Feder gemäß Anspruch 5, dadurch gekennzeichnet, daß die Dicke e der zwei Seitenarme (38, 39) ungefähr gleich der halben Dicke der restlichen Platte ist.

7. Feder gemäß Anspruch 1, dadurch gekennzeichnet, daß sie die Form eines T mit einem Mittelbalken (40) besitzt, wobei die Lasche (42, 43) in zwei auf jeder Seite des Mittelbalkens befindliche Halblaschen unterteilt ist, wobei die Breite l des Hauptteils gleich der Breite des Mittelbalkens ist, wobei die Höhe H des Mittelteils 5 gleich der Höhe des T ist, wobei die Breite l′ der Lasche gleich der doppelten Breite der Halblaschen ist und wobei die Höhe h der Lasche gleich der Höhe der Halblaschen ist.

8. Feder gemäß einem der Ansprüche 1 bis 7, dadurch gekennzeichnet, daß am Hauptteil auf der Seite des für die Befestigung an der Befestigungsfläche bestimmten Endes Seitenflanken (50, 51) vorgesehen sind.

9. Feder gemäß einem der Ansprüche 1 bis 8, dadurch gekennzeichnet, daß die Lasche um einen umgeknickten Teil (65) verlängert ist, der das Auflegen des schwingenden Plättchens gestattet.

10. Feder gemäß einem der Ansprüche 1 bis 9, dadurch gekennzeichnet, daß der Hauptteil um eine umgeknickte Grundfläche (64) verlängert ist, die die Befestigung an der Befestigungsfläche gestattet.

11. Feder gemäß einem der Ansprüche 9 bis 10, dadurch gekennzeichnet, daß Kerben (62, 63) vorgesehen sind, um das Knicken des umgeknickten Teils (65) und/oder der Grundfläche (64) zu erleichtern.


## Claims

1. A suspensionspring for a vibrating piezoelectric lamella, comprising a main part (36) with a height H, a width l, and a thickness e, said main part (36) having to be attached on one side on a seat and on the other side being connected on a first end of a tongue (35) with a height h, a width l′ and a thickness e′ the other end of the tongue (35) supporting the vibrating lamella, the latter and the seat being positioned on the same side in relation to the connection between the main part (36) and the tongue (35), characterized in that the dimensions H and h are such that $(l/l') \times (h/H)^2 + 2 \times (h/H) - 1$ is substantially equal to zero when e′ is substantially equal to e and h = H/2 when e′ is greater than or equal to twice e.

2. The spring as claimed in claim 1, characterized in that it is formed from a multiply folded band, the main part (25) and the tongue (28) being connected by an intermediate part (29) and being in planes which are substantially parallel to each other.

3. The spring as claimed 2, characterized in that, the thickness of the band being approximately constant, the distance separating the main part from the tongue amounts to approximately three times the thickness of the band.

4. The spring as claimed in claim 2 or in claim 3, characterized in that the width of the band is substantially constant, the height of the tongue being approximately half the height H of the main part.

5. The spring as claimed in claim 1, characterized in that the springs is the consequence of there being an opening in the form of a letter U symmetrically produced in a rectangular plate, the opening defining the tongue (35), the main part (36) being formed by two side branches (38 and 39) and positioned on each side of the tongue (35), the height H of the main part (36) being the height of the opening, the width l of the main part (36) being twice the width of the side branches (38 and 39), the tickness e of the main part (36) being the thickness of the two side branches (38 and 39).

6. The spring as claimed in claim 5, characterized in that the thickness e of the two side branches (38 and 39) is approximately half the thickness of the remainder of the plate.

7. The spring as claimed in claim 1, characterized in that is has the configuration of a T with a central bar (40), the tongue (42 and 43) being reduplicated as half tongues positioned on each side of the central bar, the width l of the main part being the width of the central bar, the height H of the main part being the height of the T, the width l′ of the tongue bein twice the width of the half tongues, and the height h of the tongue being the height of the half tongues.

8. The spring as claimed in any one of the preceding claims 1 through 7, characterized in that the lateral flanks (50 and 51) are provided on the main part on the side of the extremity to be fixed to the seat.

9. The spring as claimed in any one of the preceding claims 1 through 8, characterized in that the tongue is prolonged by a folded part (65) making it possible to mount the vibrating lamella.

10. The spring as claimed in any one of the preceding claims 1 through 9, characterized in that the main part is prolonged by a folded base (54) making it possible to secure it on the seat.

11. The spring as claimed in claim 9 or claim 10, characterized in that notches (62 and 63) are provided in order to facilitate the folding of the folded part (65) and/or of the base (64).

FIG_1

FIG_2

FIG_3

FIG_4

## FIG_5

29
28
27
31
25
30
26

## FIG_6

ε
h
H
e

## FIG_7

ℓᵢ
h
38    35
39
H
ℓ/2
36
37

## FIG_8

h
42
ℓ'/2
43
H
ℓ
40
41

## FIG_9

H
51
50

8

EP 0 284 474 B1

**FIG_10**

H
h

57
56
55

**FIG_11**

60 →
63
61
62
62

**FIG_12**

65
64

9